# EUROPEAN PATENT APPLICATION

(11) **EP 1 657 919 A1**
(43) Date of publication of application: **17.05.2006**
(21) Application number: 05110214.3
(22) Date of filing: 31.10.2005
(51) Int. Cl.: H04N 5/44, H04B 1/30

(54) **Zero-IF tuner for digital multimedia broadcasting**

(30) Priority: 11.11.2004 KR 2004091994
(71) Applicant: Integrant Technologies Inc., Gyeonggi-do 463-810 (KR)
(72) Inventor: Jeong, Min Su 206-1002, Eunhasu Apt., Dongan-gu Gyeonggi-do (KR)
(74) Representative: Beier, Ralph

(57) **Abstract**

The present invention relates to a receiver, and more particularly, to a Zero-IF receiving apparatus for digital multimedia broadcasting (DMB). The Zero-IF receiver for DMB according to the present invention comprises a first receiver that comprises a first mixer, a first Low-Pass Filter (LPF) and a first Low-Noise Amplifier (LNA) and forms an I channel, a second receiver that comprises a second mixer, a second LPF and a second LNA and forms a Q channel, a Phase Locked Loop (PLL), a Local Oscillator (LO) and a Phase Local Oscillator (PLO). An input terminal of each of the first mixer of the first receiver and an input terminal of the second mixer of the second receiver are connected to an output terminal of a LNA that amplifies a satellite frequency signal. Furthermore, an input terminal of the first mixer of the first receiver and an input terminal of the second mixer of the second receiver are connected to output terminals of the PLL, the LO and the PLO.

## Description

### BACKGROUND OF THE INVENTION

### Field of the Invention

The present invention relates to a receiver, and more particularly, to a Zero-IF receiving apparatus for digital multimedia broadcasting (DBM).

### Background of the Related Art

In an indirect frequency conversion receiving apparatus using an IF, frequency conversion must be performed repeatedly. As a result, non-linear characteristics are added due to the repeated frequency conversion, thereby resulting in generation of mutual modulation distortion or parasitic components.

A BandPass Filter (BPF) removes such mutual modulation distortion or parasitic components. However, using a BPF leads to increased production costs.

As a result, techniques which convert the Radio Frequency (RF) signal into the baseband signal through direct conversion (Zero-IF) without an intermediate frequency have been introduced.

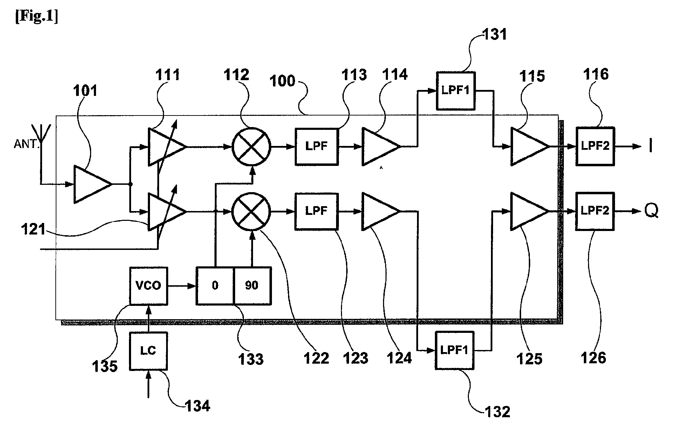

FIG. 1 is a block diagram of an existing direct conversion down-converter.

As shown in FIG. 1, a conventional tuner 100 comprises a Low-Noise Amplifier (LNA) 101 that first amplifies a weak signal received from a satellite antenna, a variable amplifier 111 that first amplifies a received Automatic Gain Control (AGC) signal and then variably amplifies the firstly amplified signal, a Local Oscillator (LO) 133 that receives a signal generated from an external LC tank 134 via an internal Voltage Control Oscillator (VCO) 135 and generates an in-phase signal, a mixer 112 that mixes the signal that has been oscillated in the LO 133 and the signal that has been amplified in the variable amplifier 111, a Low-Pass Filter (LPF) 113 that allows only the bandpass of the signal, which has been mixed in the mixer 112, to pass through, an amplifier 114 that amplifies the signal from the LPF 113, an external LPF 131 that allows only the bandpass of the signal, which has been amplified in the amplifier 114, to pass through, an amplifier 115 that amplifies the signal from the external LPF 131, an external LPF 116 which allows only the bandpass of the signal that has been amplified in the amplifier 115 to pass through and outputs a signal of a channel, variable amplifier 121 that first amplifies a received AGC signal and then variably amplifies the first amplified signal, a LO 133 that receives a signal generated from an external LC tank 134 via an internal VCO 135 and generates a quadrature-phase signal, a mixer 122 that mixes the signal that has been oscillated in the LO 133 and the signal that has been amplified in the variable amplifier 121, a LPF 123 that allows only the bandpass of the signal, which has been mixed in the mixer 122, to pass through, an amplifier 124 that amplifies the signal from the LPF 123, an external LPF 132 that allows only the bandpass of the signal, which has been amplified in the amplifier 124, to pass through, an amplifier 125 that amplifies the signal from the external LPF 132, and an external LPF 126 which allows only the bandpass of the signal that has been amplified in the amplifier 125 to pass through and outputs a signal of a Q channel.

However, the conventional tuner constructed above has the LC tank circuit and the LPF disposed outside and comprises a circuit of near Zero-IF not substantially Zero-IF. Therefore, external noise can be generated due to a lengthy signal transfer length.

Furthermore, the conventional technique cannot properly construct a wide range band using Zero-IF.

### SUMMARY OF THE INVENTION

Accordingly, the present invention has been made in view of the above problems occurring in the prior, and it is an object of the present invention to provide a Zero-IF receiving apparatus for DMB, which is constructed of a single chip, facilitating the design of a receiving apparatus.

Another object of the present invention is to provide a Zero-IF receiving apparatus for DMB, which is effective in a receiving apparatus with low power consumption.

To achieve the above objects, a Zero-IF receiver for DMB according to the present invention comprises a first receiver that comprises a first mixer, a first LPF and a first LNA and forms an I channel, a second receiver that comprises a second mixer, a second LPF and a second LNA and forms a Q channel, a oscillation portion that includes a Phase Locked Loop (PLL), a Local Oscillator (LO) and a Phase Local Oscillator (PLO). An input terminal of each of the first mixer of the first receiver and an input terminal of the second mixer of the second receiver are connected to an output terminal of a LNA that amplifies a satellite frequency signal. Furthermore, an input terminal of the first mixer of the first receiver and an input terminal of the second mixer of the second receiver are connected to output terminals of the oscillation portion.

In this case, the mixer is a down-converter mixer.

### BRIEF DESCRIPTION OF THE DRAWINGS

Further objects and advantages of the invention can be more fully understood from the following detailed description taken in conjunction with the accompanying drawings in which:

FIG. 1 is a block diagram of an existing direct conversion down-converter;

FIG. 2 is a block diagram of a Zero-Intermediate Frequency (IF) receiver for Digital Multimedia Broadcasting (DMB) according to the present invention; and

FIG. 3 is a conceptual view for illustrating gain control in FIG. 2 according to the present invention.

### DETAILED DESCRIPTION OF THE PREFERRED EMBODIMENT

The present invention will now be described in detail in connection with preferred embodiments with reference to the accompanying drawings.

A Zero-IF receiving apparatus for DMB according to the present invention will now be described in detail with reference to the accompanying drawings.

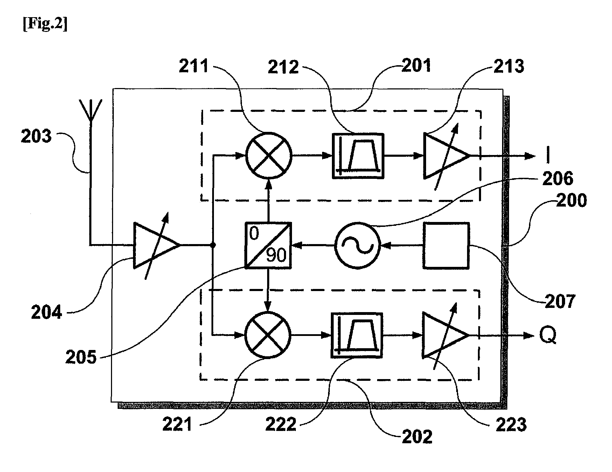

FIG. 2 is a block diagram of the IF receiver for DMB according to the present invention.

As shown in FIG. 2, a Zero-IF tuner 200 according to the present invention comprises a first receiver 201, a second receiver 202, a LNA 204 and a oscillation portion that includes a Phase Local Oscillator (PLO) 205, a LO 206 and a Phase Locked Loop (PLL) 207.

The first receiver 201 comprises a mixer 211, a LPF 212 and a LNA 213. The second receiver 202 comprises a mixer 221, a LPF 222 and a LNA 223.

The LNA 204 amplifies a weak signal received from a satellite antenna 203 while prohibiting noise from being amplified and transmits the amplified signal to the mixer 211 of the first signal unit 201 and the mixer 221 of the second signal unit 202.

The PLL 207 allows an output frequency of the LO 206 to be fixed to a constant frequency without being shaken. The PLL 207 make an output frequency of the LO 207 moved and fixed to a predetermined frequency by precisely controlling a voltage of a VCO used in the LO 206.

Furthermore, the PPL 207 comprises a frequency combiner and a VCO. The VCO is capable of processing a DMB-S frequency range.

The combiner is composed of 20-bit sigma-delta fractional-N architecture and has a good noise characteristic depending on high-speed switching, ultra-high resolution frequency and wide band.

The LO 206 oscillates a frequency that is used to convert a satellite signal into a baseband, and generates a frequency to be supplied to the mixers 211, 221.

The LO 206 structure does not have an external LC tank circuit. Therefore, there is no need to apply an external additional high voltage of about 30 V.

The PLO 205 generates an in-phase or quadrature-phase frequency.

The mixer 211 of the first receiver 201 serves as a down converter. The mixer 211 mixes a satellite frequency using the signal, which has been amplified via the satellite antenna 203 and the LNA 204, and the frequency, which has passed through the PLL 207, the LO 206 and the PLO 205, and changes the baseband frequency signal.

The LPF 212 of the first receiver 201 functions to selectively pick up a desired frequency signal from the frequency signal output from the mixer 211.

The LNA 213 of the first receiver 201 include a Programmable Gain Amplifier (PGA) and a Variable Gain Amplifier (VGA).

The frequency signal output from the LNA 213 is a frequency signal in which the satellite frequency signal is converted into a base, and forms an I channel.

The mixer 221 of the second receiver 202 is a mixer that serves as a down converter. The mixer 221 mixes the satellite frequency using the signal, which has been amplified via the satellite antenna 203 and the LNA 204, and the frequency that has passed through the PLL 207, the LO 206 and the PLO 205, and changes the frequency into a baseband frequency signal.

The LPF 222 of the second receiver 202 serves to selectively pick up a desired frequency signal from the mixer 221 output signal.

The LNA 223 of the second receiver 202 comprises a PGA and a VGA.

The frequency signal output from the LNA 223 is a frequency signal in which the satellite frequency signal is converted into the baseband and forms a Q channel.

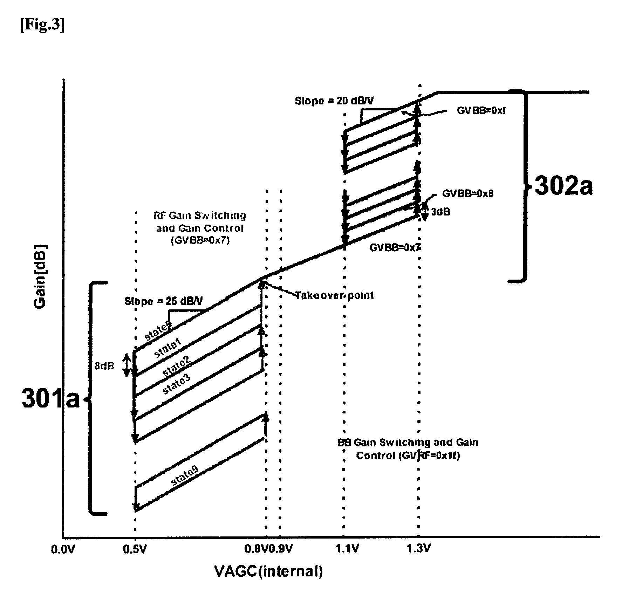

To selectively pick up a desired frequency signal using the LPF 212 and the LNA 213 of the first receiver 201 and the LPF 222 and the LNA 223 of the second receiver 202, a gain control method shown in FIG. 3 according to the present invention is employed.

FIG. 3 is a conceptual view for illustrating gain control in FIG. 2 according to the present invention.

FIG. 3 shows an output dB depending on an AGC voltage. A dotted line 301a indicates a RF gain curve, a solid line 302a indicates a baseband gain curve and an arrow indicates a step gain jump.

An arrow point voltage refers to a voltage in which a gain state is changed at a gain trip point.

A RF gain high trip point refers to a point at which a RG gain jumps to a higher gain at 0.8V. A RF gain low trip point refers to a point at which a RF gain jumps to a lower gain at 0.5V. This point indicates a RF gain low trip point.

The RF gain high/low trips are performed in a RF region. The high trip of the RF gain high trip point is decided by a RFTRH signal and the low trip of the RF gain low trip point is decided by a RFTRL signal. The high/low trip of the RF gain can be changed to signals of RFTRH/RFTRL.

A baseband gain high trip point refers to a point at which a baseband gain jumps to a higher gain at 1.3V. A baseband gain low trip point refers to a point at which a baseband gain jumps to a lower gain at 1.1V. This point indicates a 1.1V-baseband gain low trip point.

The baseband gain high/low trips are carried out in a baseband region. The high trip of the baseband gain high trip point is decided by a BBTRH signal and the low trip of the baseband gain low trip point is decided by a BBTRL signal.

FIG. 3 shows that a region is changed from the RF region to the baseband region, and a state is changed in each region.

1. RF Gain State Conversion Method

An AGC voltage is initially set to 0V. If a gain of 55dB is required, the AGC voltage is increased.

In the case where the AGC voltage exceeds 0.8V due to the increase of the AGC voltage, a RF step gain is changed from state 9 to state 8.

In the case the whole gain is smaller than 55dB although the whole gain is increased due to the increase of the AGC voltage, the VAGC voltage continues to increase.

The VAGC voltage rises up to 0.8V and the RF step gain is increase by one state.

After the VAGC voltage rises up to 0.8V, if the whole gain is higher than 55dB, the VAGC voltage is lowered until the whole gain becomes 55dB.

2. Change Method to Baseband Gain State at RF Gain State

In the case where the aforementioned whole gain needs to rise to 80dB again, the VAGC voltage continues to increase.

If it is sought to obtain the whole gain since the VAGC voltage shifts between 0.8V to 0.9V, an object to control the whole gain controls the gain of RF at 0.9V or less and controls the gain of the baseband at 0.9V or higher in order to obtain a desired output.

In the case where a desired whole gain exceeds state of the RF region, a step continues to rise until a desired gain is obtained, by increasing a baseband gain (GVBB).

3. Baseband Gain State Change Method

In the case where the aforementioned whole gain needs to rise to 80dB again, the VAGC voltage continues to increase.

If the AGC voltage exceeds 1.3V, the baseband step gain is changed by one state in the same method as the above-described RF gain sate change method.

That is, a step continues to increase until a desired gain is obtained by changing a baseband gain (GVBB) signal.

As a result, if the whole gain is lowered through this method, the VAGC voltage is reduced. If the whole gain is lower than 0.5V, state is changed to one step low. In the same manner, if a desired is low at 1.1V, the state of VAGC is changed to one step low.

Furthermore, since the minimal value of the baseband gain (GVBB) can be arbitrarily changed, gain allocation of the RF band and the baseband can be programmed.

A Zero-IF receiving apparatus for DMB, which is constructed of a single chip, according to the present invention is advantageous in that it can facilitate the design of a receiving apparatus.

In addition, the Zero-IF receiving apparatus for DMB according to the present invention is advantageous in that it is effective in a receiving apparatus with low power consumption.

While the present invention has been described with reference to the particular illustrative embodiments, it is not to be restricted by the embodiments but only by the appended claims. It is to be appreciated that those skilled in the art can change or modify the embodiments without departing from the scope and spirit of the present invention.

## Claims

1. A Zero-IF receiver for Digital Multimedia Broadcasting (DMB), comprising:
a first receiver that includes a first mixer, a first Low-Pass Filter (LPF) and a first Low-Noise Amplifier (LNA) and forms an I channel;
a second receiver that includes a second mixer, a second LPF and a second LNA and forms a Q channel;
a oscillation portion that includes a Phase Locked Loop (PLL), a Local Oscillator (LO) and a Phase Local Oscillator (PLO),
wherein an input terminal of the first mixer of the first receiver and an input terminal of the second mixer of the second receiver are connected to an output terminal of a LNA that amplifies a satellite frequency signal, and
an input terminal of the first mixer of the first receiver and an input terminal of the second mixer of the second receiver are connected to output terminals of the oscillation portion.

2. The Zero-IF receiver for DMB as claimed in claim 1,
wherein the mixer is a down-converter mixer.

3. The Zero-IF receiver for DMB as claimed in claim 1,
wherein the PLL comprises a frequency combiner and a Voltage Control Oscillator (VCO),
a frequency range of the VCO is DMB-S frequency range, and
the frequency combiner consists of a 20-bit sigma-delta fractional-N architecture.

4. The Zero-IF receiver for DMB as claimed in claim 1,
wherein the LNA of each of the first and second receiver comprises a Programmable Gain Amplifier (PGA) and a Variable Gain Amplifier (VGA).

5. The Zero-IF receiver for DMB as claimed in claim 1,
wherein gain control of the first and second receiver is switched to a gain step of a Radio Frequency (RF) band below a reference voltage and is switched to a gain step of a baseband over a reference voltage.

6. The Zero-IF receiver for DMB as claimed in claim 5,
wherein the gain step of the baseband is 3dB.

7. The Zero-IF receiver for DMB as claimed in claim 5,
wherein the gain step of each of the RF band and the baseband comprises two gain trip points.

8. The Zero-IF receiver for DMB as claimed in claim 7,
wherein the RF band gain trip point comprises a RF gain high trip point and a RF gain low trip point, and
the baseband gain trip point comprises a baseband gain high trip point and a baseband gain low trip point.

9. The Zero-IF receiver for DMB as claimed in claim 8,
wherein the RF gain high trip point is 0.8V and the baseband high trip point is 1.3V.

10. The Zero-IF receiver for DMB as claimed in claim 8,
wherein the RF gain low trip point is 0.85V and the baseband low trip point is 1.1V.

11. The Zero-IF receiver for DMB as claimed in claim 8,
wherein the RF gain high trip point is controlled according to a RFTRH signal and the RF gain low trip point is controlled according to a RFTRL signal, and
the baseband high trip point is controlled according to a BBTRH signal and the baseband low trip point is controlled according to a BBTRL signal.

12. The Zero-IF receiver for DMB as claimed in claim 8,
wherein in the baseband high trip point and the baseband low trip point, a minimal value of a baseband gain (GVBB) is programmable.
